# EUROPÄISCHE PATENTSCHRIFT

(11) **EP 2 958 871 B1**
(45) Veröffentlichungstag und Bekanntmachung des Hinweises auf die Patenterteilung: **10.03.2021**
(21) Anmeldenummer: 13811519.1
(22) Anmeldetag: 19.12.2013
(51) Int. Cl.: C03C 17/00, B32B 17/06, C03C 17/34, C03C 27/10, C08J 7/00, G02B 1/11

(54) **SCHEIBE MIT WÄRMESTRAHLUNG REFLEKTIERENDER BESCHICHTUNG**
PANE WITH COATING THAT REFLECTS THERMAL RADIATION
VITRE AVEC UN REVÊTEMENT RÉFLÉCHISSANT UN RAYONNEMENT THERMIQUE

(30) Priorität: 20.02.2013 EP 13155970
(43) Veröffentlichungstag der Anmeldung: 30.12.2015
(73) Patentinhaber: SAINT-GOBAIN GLASS FRANCE, 92400 Courbevoie (FR)
(72) Erfinder: HAGEN, Jan, 53123 Bonn (DE); MANZ, Florian, 52064 Aachen (DE)
(74) Vertreter: Gebauer, Dieter Edmund
(86) Internationale Anmeldenummer: PCT/EP2013/077352
(87) Internationale Veröffentlichungsnummer: WO 2014/127868

(56) Entgegenhaltungen:
- EP-A1- 2 141 135
- EP-A2- 0 536 607
- WO-A1-2006/043026
- WO-A1-2011/105991
- WO-A2-2012/022876
- BE-A5- 1 010 321
- US-A1- 2004 219 368
- US-B1- 6 572 990

## Beschreibung

Die Erfindung betrifft eine Scheibe mit Wärmestrahlung reflektierender Beschichtung, ein Verfahren zu deren Herstellung und deren Verwendung.

Der Innenraum eines Kraftfahrzeugs kann sich im Sommer bei hohen Umgebungstemperaturen und intensiver direkter Sonneneinstrahlung stark erwärmen. Ist die Außentemperatur geringer als die Temperatur im Fahrzeuginnenraum, was insbesondere im Winter auftritt, so wirkt eine kalte Scheibe als Wärmesenke, die von den Insassen als unangenehm empfunden wird. Auch muss eine hohe Heizleistung der Klimaanlage bereitgestellt werden, um eine Auskühlung des Innenraums über die Fahrzeugscheiben zu vermeiden.

Wärmestrahlung reflektierende Beschichtungen (sogenannte Low-E-Beschichtungen) sind bekannt. Eine solche Beschichtung reflektiert einen erheblichen Teil der Sonnenstrahlung insbesondere im Infrarotbereich, was im Sommer zu einer verringerten Erwärmung des Fahrzeuginnenraums führt. Die Beschichtung verringert außerdem die Aussendung von langwelliger Wärmestrahlung einer erwärmten Scheibe in den Fahrzeuginnenraum hinein, wenn die Beschichtung auf der dem Fahrzeuginnenraum zugewandten Oberfläche einer Scheibe aufgebracht ist. Eine solche Beschichtung verringert außerdem bei niedrigen Außentemperaturen im Winter die Abstrahlung der Wärme des Innenraums in die äußere Umgebung.

Dem Fachmann sind eine Vielzahl von Wärmestrahlung reflektierenden Beschichtungen bekannt. Solche Beschichtungen können funktionelle Schichten aus Niob, Tantal, Nickel, Chrom, Zirkonium oder Legierungen daraus enthalten, wie beispielsweise in US7592068B2, US7923131B2 und WO2004076174A1 offenbart ist. Die Beschichtungen können auch funktionelle Schichten aus Silber enthalten, wie beispielsweise aus EP 877 006 B1, EP 1 047 644 B1 und EP 1 917 222 B1 bekannt ist. Außerdem sind Beschichtungen mit funktionellen Schichten aus Indium-Zinn-Oxid bekannt, beispielsweise aus EP2141135A1, WO2010115558A1 und WO2011105991A1.

WO2012/022876 A2 zeigt eine Scheibe mit einem Dünnschichtstapel, der auf der umgebungsseitigen Oberfläche, d.h. auf der Scheibenoberfläche, die in Einbaulage vom Innenraum abgewandt ist, angeordnet ist.

US 2004/0219368 A1 beschreibt Scheiben bei denen ein Dünnschichtstapel zwischen zwei Glassubstraten angeordnet ist.

Aus ästhetischen oder thermischen Gründen kann es gewünscht sein, dass eine Fahrzeugscheibe eine verminderte Lichttransmission aufweist. Dies ist beispielsweise bei hinteren Seitenscheiben, Heckscheiben oder Dachscheiben häufig der Fall. Es ist üblich, für solche Scheiben getönte Gläser zu verwenden. Stark getönte Gläser haben jedoch den Nachteil eines hohen innenraumseitigen Reflexionsgrades im Vergleich zum Transmissionsgrad. Während von außen die geringere Transmission für eine gewünschte Erhöhung der Privatsphäre sorgt, verschlechtert sich der optische Eindruck für die Fahrzeuginsassen. Die Wahrnehmung der äußeren Umgebung für die Insassen wird gestört, insbesondere wenn der innenraumseitige Reflexionsgrad größer als der Transmissionsgrad ist. Zudem können zu starke Reflexionen für die Insassen störend oder irritierend wirken. Ist die innenraumseitige Oberfläche der Scheibe mit einer Wärmestrahlung reflektierenden Beschichtung versehen, so kann die Reflexion nicht durch herkömmliche Antireflexionsbeschichtungen einfach vermindert werden, weil die beiden Beschichtungen in der Regel optisch nicht aufeinander abgestimmt und daher nicht einfach zu kombinieren sind.

Die Aufgabe der vorliegenden Erfindung besteht darin, eine verbesserte Scheibe mit Wärmestrahlung reflektierender Beschichtung sowie ein Verfahren zu ihrer Herstellung bereitzustellen. Die Scheibe soll bei geringer Lichttransmission eine verminderte innenraumseitige Reflexion aufweisen.

Die Aufgabe der vorliegenden Erfindung wird erfindungsgemäß durch eine Scheibe mit Wärmestrahlung reflektierender Beschichtung gemäß Anspruch 1 gelöst. Bevorzugte Ausführungen gehen aus den Unteransprüchen hervor.

Die erfindungsgemäße Scheibe mit Wärmestrahlung reflektierender Beschichtung, umfasst mindestens ein Substrat und mindestens eine Wärmestrahlung reflektierende Beschichtung mindestens auf der innenraumseitigen Oberfläche des Substrats, d.h. auf der Oberfläche des Substrats, die dafür vorgesehen ist, in Einbaulage der Scheibe dem Innenraum zugewandt zu sein, wobei die Scheibe eine Transmission im sichtbaren Spektralbereich von kleiner als 5 % aufweist und wobei die Beschichtung ausgehend vom Substrat mindestens
- eine Haftschicht, welche zumindest ein Material mit einem Brechungsindex von kleiner als 1,8 enthält,
- eine funktionelle Schicht, die zumindest ein transparentes, elektrisch leitfähiges Oxid (TCO) enthält,
- eine optisch hochbrechende Schicht, welche zumindest ein Material mit einem Brechungsindex von größer oder gleich 1,8 enthält, und
- eine optisch niedrigbrechende Schicht, welche zumindest ein Material mit einem Brechungsindex von kleiner als 1,8 enthält, umfasst.

Die erfindungsgemäße Scheibe ist dafür vorgesehen, in einer Öffnung, beispielsweise eines Fahrzeugs oder eines Gebäudes, den Innenraum gegenüber der äußeren Umgebung abzutrennen. Die Oberfläche, die dafür vorgesehen ist, in Einbaulage der Scheibe dem Innenraum zugewandt zu sein, wird im Sinne der Erfindung als innenraumseitige Oberfläche bezeichnet. Die erfindungsgemäße Beschichtung ist erfindungsgemäß auf der innenraumseitigen Oberfläche des Substrats, d.h. auf der Oberfläche des Substrats, die dafür vorgesehen ist, in Einbaulage der Scheibe dem Innenraum zugewandt zu sein, angeordnet. Das ist besonders vorteilhaft im Hinblick auf den thermischen Komfort im Innenraum. Die erfindungsgemäße Beschichtung kann dabei bei hohen Außentemperaturen und Sonneneinstrahlung besonders effektiv die von der gesamten Scheibe in Richtung des Innenraums abgestrahlte Wärmestrahlung zumindest teilweise reflektieren. Bei niedrigen Außentemperaturen kann die erfindungsgemäße Beschichtung effektiv die aus dem Innenraum abgestrahlte Wärmestrahlung reflektieren und somit die Wirkung der kalten Scheibe als Wärmesenke verringern.

Der große Vorteil der Erfindung liegt in der Verbindung einer Scheibe mit sehr geringer Lichttransmission und der erfindungsgemäßen Wärmestrahlung reflektierenden Beschichtung. Die geringe Lichttransmission der Scheibe wird typischerweise durch ein getöntes Substrat und/oder getönte mit dem Substrat verbundene Schichten (beispielsweise eine weitere Scheibe und eine Polymerfolie in einem Verbundglas) erreicht. Eine solche Scheibe weist an sich einen hohen innenraumseitigen Reflexionsgrad auf. Von Personen, die sich in dem von der Scheibe begrenzten Innenraum befinden, wird die ausgeprägte Reflexion häufig als störend oder sogar irritierend wahrgenommen. Dies gilt insbesondere dann, wenn der innenraumseitige Reflexionsgrad größer ist als der Transmissionsgrad, wodurch die Wahrnehmung der äußeren Umgebung gestört oder verhindert wird. Es hat sich überraschend gezeigt, dass die erfindungsgemäße Beschichtung neben der Wärmestrahlung reflektierenden Wirkung auf eine reflexionsmindernde Wirkung aufweist. Durch die erfindungsgemäße Beschichtung wird der innenraumseitige Reflexionsgrad vorteilhaft vermindert und das Verhältnis des Transmissionsgrads zum innenraumseitigen Reflexionsgrad vorteilhaft erhöht.

Die erfindungsgemäße Wärmestrahlung reflektierende Beschichtung ist ein Schichtaufbau, welcher zumindest die folgenden Schichten umfasst:
- die erfindungsgemäße Haftschicht,
- oberhalb der Haftschicht die erfindungsgemäße funktionelle Schicht,
- oberhalb der funktionellen Schicht die erfindungsgemäße optisch hochbrechende Schicht und
- oberhalb der optisch hochbrechende Schicht die erfindungsgemäße optisch niedrigbrechende Schicht.

Ist eine erste Schicht oberhalb einer zweiten Schicht angeordnet, so bedeutet dies im Sinne der Erfindung, dass die erste Schicht weiter vom Substrat entfernt angeordnet ist als die zweite Schicht. Ist eine erste Schicht unterhalb einer zweiten Schicht angeordnet ist, so bedeutet dies im Sinne der Erfindung, dass die zweite Schicht weiter vom Substrat entfernt angeordnet ist als die erste Schicht.

Ist eine erste Schicht oberhalb oder unterhalb einer zweiten Schicht angeordnet, so bedeutet dies im Sinne der Erfindung nicht notwendigerweise, dass sich die erste und die zweite Schicht in direktem Kontakt miteinander befinden. Es können eine oder mehrere weitere Schichten zwischen der ersten und der zweiten Schicht angeordnet sein, sofern dies nicht explizit ausgeschlossen wird.

Die oberste Schicht der Beschichtung ist im Sinne der Erfindung diejenige Schicht, welche den größten Abstand zum Substrat aufweist. Die unterste Schicht der Beschichtung ist im Sinne der Erfindung diejenige Schicht, welche den geringsten Abstand zum Substrat aufweist.

Enthält eine Schicht oder ein sonstiges Element zumindest ein Material, so schließt das im Sinne der Erfindung den Fall ein, dass die Schicht aus dem Material besteht.

Oxide und Nitride können grundsätzlich stöchiometrisch, unterstöchiometrisch oder überstöchiometrisch in Bezug auf den Sauerstoffgehalt beziehungsweise Stickstoffgehalt sein.

Die angegebenen Werte für Brechungsindizes sind bei einer Wellenlänge von 550 nm gemessen.

Die innenraumseitige Emissivität der erfindungsgemäßen Scheibe beträgt bevorzugt kleiner oder gleich 35%, besonders bevorzugt kleiner oder gleich 25%, ganz besonders bevorzugt kleiner oder gleich 20%. Mit innenraumseitiger Emissivität wird dabei das Maß bezeichnet, welches angibt, wie viel Wärmestrahlung die Scheibe in Einbaulage im Vergleich zu einem idealen Wärmestrahler (einem schwarzen Körper) in einen Innenraum, beispielsweise eines Gebäudes oder eines Fahrzeugs abgibt. Unter Emissivität wird im Sinne der Erfindung der normale Emissionsgrad bei 283 K nach der Norm EN 12898 verstanden.

Die erfindungsgemäße Scheibe weist bevorzugt eine Transmission im sichtbaren Spektralbereich von kleiner als 4 %, besonders bevorzugt kleiner als 3 % auf. Bei Scheiben mit einer so geringen Transmission wird der innenraumseitige Reflexionsgrad besonders vorteilhaft verringert.

Das Verhältnis T_{L}/R_{L} des innenraumseitigen Transmissionsgrads T_{L} im sichtbaren Spektralbereich zum innenraumseitigen Reflexionsgrad R_{L} im sichtbaren Spektralbereich beträgt bevorzugt größer oder gleich 0,6, besonders bevorzugt größer oder gleich 0,8, ganz besonders bevorzugt größer oder gleich 1 und insbesondere größer oder gleich 1,5. Das ist besonders vorteilhaft im Hinblick auf eine angenehme Wahrnehmung der äußeren Umgebung durch einen Betrachter im Innenraum.

Der innenraumseitige Transmissionsgrad beschreibt dabei den Anteil der Strahlung, welche von außen durch die Scheibe hindurch in den Innenraum dringt, an der von außen auf die Scheibe treffenden Strahlung im sichtbaren Spektralbereich. Der innenraumseitige Reflexionsgrad beschreibt den Anteil der Strahlung, welche in den Innenraum zurückreflektiert wird, an der vom Innenraum aus auf die Scheibe treffenden Strahlung im sichtbaren Spektralbereich.

Der Wert der erfindungsgemäßen Scheibe für den Gesamtenergieeintrag durch Sonnenstrahlung beträgt bevorzugt kleiner 50 %, besonders bevorzugt kleiner 40 %, ganz besonders bevorzugt kleiner 30 %, insbesondere kleiner 20 %. Dieser Wert ist dem Fachmann auch als TTS-Wert ("total transmitted sun") bekannt.

Der Flächenwiderstand der erfindungsgemäßen Beschichtung beträgt bevorzugt von 10 Ohm/Quadrat bis 50 Ohm/Quadrat, besonders bevorzugt von 15 Ohm/Quadrat bis 30 Ohm/Quadrat.

In einer vorteilhaften Ausgestaltung der Erfindung ist die erfindungsgemäße Scheibe eine Verbundscheibe. Dabei ist das Substrat über zumindest eine thermoplastische Zwischenschicht mit einer Deckscheibe verbunden. Die Deckscheibe ist dafür vorgesehen, in Einbaulage der Verbundscheibe der äußeren Umgebung zugewandt zu sein, während das Substrat dem Innenraum zugewandt ist. Die erfindungsgemäße Beschichtung ist auf der von der Deckscheibe abgewandten Oberfläche des Substrats angeordnet, welche die innenraumseitige Oberfläche der Verbundscheibe ist.

Das Substrat und gegebenenfalls die Deckscheibe enthalten bevorzugt Glas, besonders bevorzugt Flachglas, Floatglas, Quarzglas, Borsilikatglas, Kalk-Natron-Glas oder Kunststoffe, vorzugsweise starre Kunststoffe, insbesondere Polyethylen, Polypropylen, Polycarbonat, Polymethylmethacrylat, Polystyrol, Polyamid, Polyester, Polyvinylchlorid und / oder Gemische davon. Das Substrat und gegebenenfalls die Deckscheibe weisen bevorzugt eine Dicke von 1,0 mm bis 25 mm und besonders bevorzugt von 1,4 mm bis 4,9 mm auf.

Ist die erfindungsgemäße Scheibe eine Verbundscheibe, so enthält die thermoplastische Zwischenschicht bevorzugt thermoplastische Kunststoffe, beispielsweise Polyvinylbutyral (PVB), Ethylenvinylacetat (EVA), Polyurethan (PU), Polyethylenterephthalat (PET) oder mehrere Schichten davon, bevorzugt mit Dicken von 0,3 mm bis 0,9 mm.

Die Scheibe weist erfindungsgemäß eine Transmission im sichtbaren Spektralbereich von kleiner oder gleich 5 % auf. Das Substrat ist dazu bevorzugt entsprechend getönt und/oder gefärbt. Ist die Scheibe eine Verbundscheibe, so können alternativ oder zusätzlich auch die Deckscheibe und/oder die thermoplastische Zwischenschicht gefärbt und/oder getönt sein. Im Falle einer Verbundscheibe weist das Substrat und die Deckscheibe bevorzugt jeweils eine Transmission im sichtbaren Spektralbereich von kleiner 35 %, besonders bevorzugt kleiner 30 % auf. Die thermoplastische Zwischenschicht weist bevorzugt eine Transmission von 20 % bis 80% auf, besonders bevorzugt von 20 % bis 70%, ganz besonders bevorzugt von 20 % bis 50%.

Die funktionelle Schicht weist reflektierende Eigenschaften gegenüber Wärmestrahlung, insbesondere Infrarotstrahlung auf, ist im sichtbaren Spektralbereich jedoch weitgehend transparent. Die funktionelle Schicht enthält erfindungsgemäß zumindest ein transparentes, elektrisch leitfähiges Oxid (*transparent conductive oxide,* TCO). Der Brechungsindex des transparenten, elektrisch leitfähigen Oxids beträgt bevorzugt von 1,7 bis 2,3. Die funktionelle Schicht enthält bevorzugt zumindest Fluor-dotiertes Zinnoxid (SnO₂:F), Antimon-dotiertes Zinnoxid (SnO₂:Sb) und/oder Indium-Zinn-Oxid (ITO), besonders bevorzugt Indium-Zinn-Oxid (ITO). Damit werden besonders gute Ergebnisse hinsichtlich der Emissivität und der Biegbarkeit der erfindungsgemäßen Beschichtung erreicht.

Das Indium-Zinn-Oxid wird bevorzugt mittels magnetfeldunterstützter Kathodenzerstäubung mit einem Target aus Indium-Zinn-Oxid abgeschieden. Das Target enthält bevorzugt von 75 Gew. % bis 95 Gew. % Indiumoxid und von 5 Gew. % bis 25 Gew. % Zinnoxid sowie herstellungsbedingte Beimengungen. Die Abscheidung des Indium-Zinn-Oxids erfolgt bevorzugt unter einer Schutzgasatmosphäre, beispielsweise Argon. Dem Schutzgas kann auch ein geringer Anteil an Sauerstoff zugesetzt werden, beispielsweise um die Homogenität der funktionellen Schicht zu verbessern.

Das Target kann alternativ bevorzugt zumindest von 75 Gew. % bis 95 Gew. % Indium und von 5 Gew. % bis 25 Gew. % Zinn enthalten. Die Abscheidung des Indium-Zinn-Oxids erfolgt dann bevorzugt unter Zugabe von Sauerstoff als Reaktionsgas während der Kathodenzerstäubung.

Die funktionelle Schicht kann aber auch andere transparente, elektrisch leitfähige Oxide enthalten, beispielsweise Indium-Zink-Mischoxid (IZO), Gallium-dotiertes oder Aluminium-dotiertes Zinkoxid, Niobium-dotiertes Titanoxid, Cadmiumstannat und/oder Zinkstannat.

Die Dicke der funktionellen Schicht beträgt bevorzugt von 50 nm bis 150 nm, besonders bevorzugt von 60 nm bis 140 nm und ganz besonders bevorzugt von 70 nm bis 130 nm. In diesem Bereich für die Dicke der funktionellen Schicht wird einerseits ein vorteilhafte antireflektierende Wirkung und andererseits eine niedrige Emissivität erreicht.

Die optisch hochbrechende Schicht bewirkt insbesondere eine Anpassung der Reflexionsfarbe der erfindungsgemäßen Scheibe. Darüber hinaus kann durch die optisch hochbrechende Schicht die Stabilität sowie die Korrosions- und Oxidationsbeständigkeit der funktionellen Schicht verbessert werden. Dies ist insbesondere dann vorteilhaft, wenn die mit der Beschichtung versehende Scheibe einer Temperaturbehandlung, einem Biegeprozess und/oder einem Vorspannprozess unterzogen werden soll.

Der Brechungsindex des Materials der optisch hochbrechenden Schicht beträgt bevorzugt von 1,7 bis 2,3 und ist besonders bevorzugt größer oder gleich dem Brechungsindex des Materials der funktionellen Schicht. Dadurch werden vorteilhafte optische Eigenschaften der Beschichtung erreicht, insbesondere ein ästhetischer Farbeindruck.

Die optisch hochbrechende Schicht enthält bevorzugt zumindest ein Oxid oder Nitrid, besonders bevorzugt Wolframoxid, Nioboxid, Tantaloxid, Zirkoniumoxid, Hafniumoxid, Bismutoxid, Titanoxid, Siliziumnitrid, Zirkoniumnitrid, Hafniumnitrid, und/oder Aluminiumnitrid. Die optisch hochbrechende Schicht enthält besonders bevorzugt Siliziumnitrid (Si₃N₄). Damit werden besonders gute Ergebnisse hinsichtlich der Stabilität der Beschichtung und der optischen Eigenschaften erzielt. Das Siliziumnitrid kann Dotierungen aufweisen, beispielsweise Titan, Zirkonium, Bor, Hafnium und / oder Aluminium. Das Siliziumnitrid ist ganz besonders bevorzugt mit Aluminium dotiert (SiₛN₄:Al) oder mit Zirkonium dotiert (Si₃N₄:Zr) oder mit Bor dotiert (Si₃N₄:B). Das ist besonders vorteilhaft im Hinblick auf die optischen Eigenschaften und die Emissivität der Beschichtung sowie die Geschwindigkeit des Aufbringens der optisch hochbrechenden Schicht beispielsweise durch Kathodenzerstäubung.

Das Siliziumnitrid wird bevorzugt mittels magnetfeldunterstützter Kathodenzerstäubung abgeschieden mit einem Target, das zumindest Silizium enthält. Das Target zur Abscheidung einer Schicht enthaltend Aluminium-dotiertes Siliziumnitrid enthält bevorzugt von 80 Gew. % bis 95 Gew. % Silizium und von 5 Gew. % bis 20 Gew. % Aluminium sowie herstellungsbedingte Beimengungen. Das Target zur Abscheidung einer Schicht enthaltend Bor-dotiertes Siliziumnitrid enthält bevorzugt von 99,9990 Gew. % bis 99,9999 Gew. % Silizium und von 0,0001 Gew. % bis 0,001 Gew. % Bor sowie herstellungsbedingte Beimengungen. Das Target zur Abscheidung einer Schicht enthaltend Zirkonium-dotiertes Siliziumnitrid enthält bevorzugt von 60 Gew. % bis 90 Gew. % Silizium und von 10 Gew. % bis 40 Gew. % Zirkonium sowie herstellungsbedingte Beimengungen. Die Abscheidung des Siliziumnitrids erfolgt bevorzugt unter Zugabe von Stickstoff als Reaktionsgas während der Kathodenzerstäubung.

Die Dicke der optisch hochbrechenden Schicht beträgt bevorzugt kleiner als 20 nm, besonders bevorzugt kleiner als 12 nm, ganz besonders bevorzugt kleiner als 10 nm und insbesondere kleiner als 8 nm. Die Dicke der optisch hochbrechenden Schicht sollte mindestens 1 nm, bevorzugt mindestens 2 nm betragen. In diesem Bereich für die Dicke der optisch hochbrechenden Schicht werden besonders vorteilhafte antireflektierende Eigenschaften der erfindungsgemäßen Beschichtung erreicht. Die Dicke beträgt bevorzugt von 1 nm bis 20 nm, besonders bevorzugt von 2 nm bis 12 nm, ganz besonders bevorzugt von 2 nm bis 10 nm und insbesondere von 2 nm bis 8 nm.

Bei einer Temperaturbehandlung nach dem Aufbringen der erfindungsgemäßen Beschichtung kann das Siliziumnitrid teilweise oxidiert werden. Eine als Si₃N₄ abgeschiedene Schicht enthält dann nach der Temperaturbehandlung SiₓN_{y}O_{z}, wobei der Sauerstoffgehalt typischerweise von 0 Atom-% bis 35 Atom-% beträgt.

Die Haftschicht führt zu einer dauerhaft stabilen Haftung der oberhalb der Haftschicht abgeschiedenen Schichten auf dem Substrat. Die Haftschicht verhindert weiter die Anreicherung von aus dem Substrat diffundierenden Ionen im Grenzbereich zur funktionellen Schicht, insbesondere von Natriumionen, falls das Substrat aus Glas besteht. Solche Ionen können zur Korrosion und zu einer geringen Haftung der funktionellen Schicht führen. Die Haftschicht ist daher besonders vorteilhaft im Hinblick auf die Stabilität der funktionellen Schicht.

Die Haftschicht enthält bevorzugt zumindest ein Material mit einem Brechungsindex zwischen 1,5 und 1,8. Das Material der Haftschicht weist bevorzugt einen Brechungsindex im Bereich des Brechungsindexes des Substrats auf. Die Haftschicht kann beispielsweise zumindest ein Oxid und/oder ein Nitrid enthalten, bevorzugt zumindest ein Oxid. Die Haftschicht enthält besonders bevorzugt Siliziumdioxid (SiO₂). Das ist besonders vorteilhaft im Hinblick auf die Haftung der oberhalb der Haftungsschicht abgeschiedenen Schichten auf dem Substrat. Das Siliziumdioxid kann Dotierungen aufweisen, beispielsweise Fluor, Kohlenstoff, Stickstoff, Bor, Phosphor und / oder Aluminium. Das Siliziumdioxid ist ganz besonders bevorzugt mit Aluminium dotiert (SiO₂:Al), mit Bor dotiert (SiO₂:B) oder mit Zirkonium dotiert (SiO₂:Zr). Das ist besonders vorteilhaft im Hinblick auf die optischen Eigenschaften der Beschichtung sowie die Geschwindigkeit des Aufbringens der Haftschicht beispielsweise durch Kathodenzerstäubung.

Das Siliziumdioxid wird bevorzugt mittels magnetfeldunterstützter Kathodenzerstäubung mit einem Target abgeschieden, welches zumindest Silizium enthält. Das Target zur Abscheidung einer Haftschicht enthaltend Aluminium-dotiertes Siliziumdioxid enthält bevorzugt von 80 Gew. % bis 95 Gew. % Silizium und von 5 Gew. % bis 20 Gew. % Aluminium sowie herstellungsbedingte Beimengungen. Das Target zur Abscheidung einer Haftschicht enthaltend Bor-dotiertes Siliziumdioxid enthält bevorzugt von 99,9990 Gew. % bis 99,9999 Gew. % Silizium und von 0,0001 Gew. % bis 0,001 Gew. % Bor sowie herstellungsbedingte Beimengungen. Das Target zur Abscheidung einer Haftschicht enthaltend Zirkonium-dotiertes Siliziumdioxid enthält bevorzugt von 60 Gew. % bis 90 Gew. % Silizium und von 10 Gew. % bis 40 Gew. % Zirkonium sowie herstellungsbedingte Beimengungen. Die Abscheidung des Siliziumdioxids erfolgt bevorzugt unter Zugabe von Sauerstoff als Reaktionsgas während der Kathodenzerstäubung.

Die Dotierung der Haftschicht kann auch die Glätte der oberhalb der Haftschicht aufgebrachten Schichten verbessern. Eine hohe Glätte der Schichten ist besonders günstig bei Verwendung der erfindungsgemäßen Scheibe im Kraftfahrzeugbereich, da hierdurch eine unangenehme raue Haptik der Scheiben vermieden wird. Ist die erfindungsgemäße Scheibe eine Seitenscheibe, so kann sie mit geringer Reibung zu den Dichtlippen bewegt werden.

Die Haftschicht kann alternativ aber auch beispielsweise Aluminiumoxid (Al₂O₃) enthalten.

Die Haftschicht weist bevorzugt eine Dicke von 10 nm bis 150 nm auf, besonders bevorzugt von 15 nm bis 50 nm, beispielsweise etwa 30 nm. Das ist besonders vorteilhaft im Hinblick auf die Haftung der erfindungsgemäßen Beschichtung und die Vermeidung der Diffusion von Ionen vom Substrat in die funktionelle Schicht.

Unterhalb der Haftschicht kann auch eine zusätzliche optisch wirksame Schicht angeordnet sein, bevorzugt mit einer Dicke von 5 nm bis 40 nm. Beispielsweise kann die Haftschicht SiO₂ enthalten und die zusätzliche optisch wirksame Schicht kann zumindest ein Oxid wie TiO₂, Al₂O₃, Ta₂O₅, Y₂O₃, ZnO und / oder ZnSnOₓ, oder ein Nitrid wie AIN oder Si₃N₄ enthalten. Durch die optisch wirksame Schicht werden die antireflektierenden Eigenschaften der erfindungsgemäßen Beschichtung vorteilhaft weiter verbessert. Außerdem ermöglicht die optisch wirksame Schicht eine verbesserte Anpassung der Farbwerte in Transmission bzw. Reflexion.

Die optisch niedrigbrechende Schicht ist entscheidend für die antireflektierende Wirkung der erfindungsgemäßen Beschichtung. Durch die optisch niedrigbrechende Schicht wird außerdem ein neutralerer Farbeindruck von reflektiertem und transmittiertem Licht erreicht und die Korrosionsbeständigkeit der funktionellen Schicht verbessert.

Die optisch niedrigbrechende Schicht kann beispielsweise zumindest ein Oxid und/oder ein Nitrid enthalten. Die optisch niedrigbrechende Schicht enthält bevorzugt zumindest ein Oxid, besonders bevorzugt zumindest Siliziumoxid (SiO₂). Das ist besonders vorteilhaft im Hinblick auf die optischen Eigenschaften der Scheibe und die Korrosionsbeständigkeit der funktionellen Schicht. Das Siliziumdioxid kann Dotierungen aufweisen, beispielsweise Fluor, Kohlenstoff, Stickstoff, Bor, Phosphor und / oder Aluminium. Das Siliziumoxid ist ganz besonders bevorzugt mit Aluminium dotiert (SiO₂:Al), mit Bor dotiert (SiO₂:B) oder mit Zirkonium dotiert (SiO₂:Zr). Damit werden besonders gute Ergebnisse erzielt.

Die optisch niedrigbrechende Schicht kann alternativ aber auch beispielsweise Aluminiumoxid (Al₂O₃) enthalten.

Die optisch niedrigbrechende Schicht weist bevorzugt eine Dicke von 40 nm bis 130 nm auf, besonders bevorzugt von 50 nm bis 120 nm, ganz besonders bevorzugt von 60 nm bis 110 nm und insbesondere von 70 nm bis 100 nm. Das ist besonders vorteilhaft im Hinblick auf eine geringe Reflexion und eine hohe Transmission von sichtbarem Licht sowie die Einstellung eines gezielten Farbeindrucks der Scheibe und die Korrosionsbeständigkeit der funktionellen Schicht. In diesem Bereich für die Dicke der optisch niedrigbrechenden Schicht werden besonders vorteilhafte antireflektierende Eigenschaften der erfindungsgemäßen Beschichtung erreicht.

In einer vorteilhaften Ausgestaltung der Erfindung ist oberhalb der optisch hochbrechenden Schicht eine Abdeckschicht angeordnet. Die Abdeckschicht schützt die erfindungsgemäße Beschichtung vor Beschädigungen, insbesondere vor Verkratzen. Die Abdeckschicht enthält bevorzugt zumindest ein Oxid, besonders bevorzugt zumindest TiO₂, ZrO₂, HfO₂, Nb₂O₅, Ta₂O₅, Cr₂O₃, WO₃ und / oder CeO₂. Die Dicke der Abdeckschicht beträgt bevorzugt von 2 nm bis 50 nm, besonders bevorzugt von 5 nm bis 20 nm. Damit werden besonders gute Ergebnisse hinsichtlich der Kratzfestigkeit erzielt.

In einer vorteilhaften Ausgestaltung ist unterhalb der Haftschicht keine Schicht angeordnet mit einem Brechungsindex größer als der Brechungsindex der Haftschicht und ist oberhalb der optisch niedrigbrechenden Schicht keine Schicht angeordnet mit einem Brechungsindex größer als der Brechungsindex der optisch niedrigbrechenden Schicht. Das ist besonders vorteilhaft im Hinblick auf die optischen Eigenschaften der Scheibe und einen einfachen Schichtaufbau.

Die erfindungsgemäße Scheibe kann plan oder leicht oder stark in einer Richtung oder in mehreren Richtungen des Raumes gebogen sein. Solche gebogenen Scheiben treten insbesondere für Verglasungen im Fahrzeugbereich auf. Typische Krümmungsradien der gebogenen Scheiben liegen im Bereich von etwa 10 cm bis etwa 40 m. Es hat sich gezeigt, dass die erfindungsgemäße Beschichtung besonders dafür geeignet ist, einen Biegeprozess ohne Beschädigungen wie beispielsweise Risse zu überstehen.

Die erfindungsgemäße Beschichtung kann ganzflächig auf die Oberfläche des Substrates aufgebracht sein. Die Oberfläche des Substrats kann aber auch beschichtungsfreie Bereiche aufweisen. Die Oberfläche des Substrats kann beispielsweise einen umlaufenden beschichtungsfreien Randbereich und / oder einen beschichtungsfreien Bereich, welcher als Datenübertragungsfenster oder Kommunikationsfenster dient, aufweisen. Die Scheibe ist in dem beschichtungsfreien Bereich für elektromagnetische und insbesondere infrarote Strahlung durchlässig.

Ist die erfindungsgemäße Scheibe eine Verbundscheibe, so ist in einer vorteilhaften Ausgestaltung auf der der Deckscheibe zugewandten Oberfläche des Substrats, auf der dem Substrat zugewandten Oberfläche der Deckscheibe oder auf einer Trägerfolie in der thermoplastischen Zwischenschicht eine Sonnenschutzbeschichtung aufgebracht. Die Sonnenschutzbeschichtung ist dort vorteilhaft vor Korrosion und mechanischer Beschädigung geschützt. Die Sonnenschutzbeschichtung umfasst bevorzugt zumindest eine metallische Schicht auf Basis von Silber oder einer silberhaltigen Legierung mit einer Dicke von 5 nm bis 25 nm. Besonders gute Ergebnisse werden mit zwei oder drei funktionellen Schichten erzielt, die durch dielektrische Schichten mit Dicken von 10 nm bis 100 nm voneinander getrennt sind. Die Sonnenschutzbeschichtung reflektiert Anteile der einfallenden Sonnenstrahlung außerhalb des sichtbaren Spektralbereichs, insbesondere im infraroten Spektralbereich. Durch die Sonnenschutzbeschichtung wird die Aufheizung des Innenraums durch direkte Sonneneinstrahlung verringert. Zudem verringert die Sonnenschutzbeschichtung die Erwärmung der in Einfallsrichtung der Sonnenstrahlung hinter der Sonnenschutzbeschichtung angeordneten Elemente der Verbundscheibe und damit die von der Verbundscheibe ausgesandte Wärmestrahlung. Durch die Kombination der Sonnenschutzbeschichtung mit der erfindungsgemäßen Beschichtung zur Reflexion von Wärmestrahlung wird der thermische Komfort im Innenraum vorteilhaft weiter verbessert.

Die Erfindung umfasst weiter ein Verfahren zur Herstellung einer erfindungsgemäßen Scheibe mit Wärmestrahlung reflektierender Beschichtung, wobei auf die innenraumseitige Oberfläche eines Substrats, d.h. auf die Oberfläche des Substrats, die dafür vorgesehen ist, in Einbaulage der Scheibe dem Innenraum zugewandt zu sein, nacheinander zumindest
(a) eine Haftschicht (3), welche zumindest ein Material mit einem Brechungsindex von kleiner als 1,8 enthält,
(b) eine funktionelle Schicht (4), die zumindest ein transparentes, elektrisch leitfähiges Oxid (TCO) enthält,
(c) eine optisch hochbrechende Schicht (5), welche zumindest ein Material mit einem Brechungsindex von größer oder gleich als 1,8 enthält, und
(d) eine optisch niedrigbrechende Schicht (6), welche zumindest ein Material mit einem Brechungsindex von kleiner als 1,8 enthält,
aufgebracht werden.

Die einzelnen Schichten werden durch an sich bekannte Verfahren abgeschieden, bevorzugt durch magnetfeldunterstützte Kathodenzerstäubung. Das ist besonders vorteilhaft im Hinblick auf eine einfache, schnelle, kostengünstige und gleichmäßige Beschichtung des Substrats. Die Kathodenzerstäubung erfolgt in einer Schutzgasatmosphäre, beispielsweise aus Argon, beziehungsweise in einer Reaktivgasatmosphäre, beispielsweise durch Zugabe von Sauerstoff oder Stickstoff.

Die einzelnen Schichten können aber auch durch andere, dem Fachmann bekannte Verfahren aufgebracht werden, beispielsweise durch Aufdampfen oder chemische Gasphasenabscheidung (chemical vapour deposition, CVD), durch Atomlagenabscheidung (atomic layer deposition, ALD), durch plasmagestützte Gasphasenabscheidung (PECVD) oder durch nasschemische Verfahren.

Die Scheibe wird bevorzugt nach dem Aufbringen der Wärmestrahlung reflektierenden Beschichtung einer Temperaturbehandlung unterzogen. Dabei wird das Substrat mit der erfindungsgemäßen Beschichtung auf eine Temperatur von mindestens 200°C, besonders bevorzugt mindestens 300°C erhitzt. Durch die Temperaturbehandlung wird insbesondere die Kristallinität der funktionellen Schicht verbessert. Die Temperaturbehandlung verringert insbesondere den Flächenwiderstand der Beschichtung, was zu einer verringerten Emissivität und verbesserten reflektierenden Eigenschaften gegenüber Wärmestrahlung führt. Außerdem werden die optischen Eigenschaften der Scheibe deutlich verbessert.

In einer vorteilhaften Ausführung des erfindungsgemäßen Verfahrens erfolgt die Temperaturbehandlung im Rahmen eines Biegeprozesses. Dabei wird das Substrat mit der erfindungsgemäßen Beschichtung im erhitzten Zustand in eine oder mehrere Richtungen des Raumes gebogen. Die Temperatur, auf die das Substrat erhitzt wird, beträgt bevorzugt von 500°C bis 700°C. Es ist ein besonderer Vorteil der erfindungsgemäßen Beschichtung zur Reflexion von Wärmestrahlung, dass sie einem solchen Biegeprozess unterzogen werden kann, ohne dabei beschädigt zu werden. Die erfindungsgemäße Abdunklungsschicht wird während des Biegeprozesses nicht beschädigt, beispielsweise durch Risse.

Natürlich können zeitlich vor oder nach dem Biegeprozess weitere Temperaturbehandlungsschritte erfolgen. Eine Temperaturbehandlung kann alternativ auch mittels Laserstrahlung durchgeführt werden.

Das Substrat kann in einer vorteilhaften Ausführung nach der Temperaturbehandlung und gegebenenfalls nach dem Biegen mit einer Vorspannung oder Teilvorspannung versehen werden. Dazu wird das Substrat in an sich bekannter Weise geeignet abgekühlt. Ein vorgespanntes Substrat weist typischerweise Oberflächendruckspannungen von mindestens 69 MPa auf. Ein teilvorgespanntes Substrat weist typischerweise Oberflächendruckspannungen von 24 MPa bis 52 MPa auf. Ein vorgespanntes Substrat eignet sich als Einscheibensicherheitsglas beispielsweise als Seitenscheibe oder Heckscheibe eines Kraftfahrzeugs.

In einer vorteilhaften Ausführung der Erfindung wird das Substrat nach dem Aufbringen der Beschichtung über zumindest eine thermoplastische Zwischenschicht mit einer Deckscheibe zu einer Verbundscheibe verbunden. Prinzipiell kann das Substrat auch zuerst mit der Deckscheibe verbunden und anschließend mit der Beschichtung versehen werden.

Die Erfindung umfasst weiter die Verwendung der erfindungsgemäßen Scheibe mit Wärmestrahlung reflektierender Beschichtung in Gebäuden, als Einbauteil in Möbeln und Geräten oder in Fortbewegungsmitteln für den Verkehr auf dem Lande, in der Luft oder zu Wasser, insbesondere in Zügen, Schiffen und Kraftfahrzeugen beispielsweise als Heckscheibe, Seitenscheibe und / oder Dachscheibe.

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Fig. 1: einen Querschnitt durch eine Ausgestaltung der erfindungsgemäßen Scheibe mit Wärmestrahlung reflektierender Beschichtung,
- Fig. 2: einen Querschnitt durch eine weitere Ausgestaltung der erfindungsgemäßen Scheibe mit Wärmestrahlung reflektierender Beschichtung,
- Fig. 3: einen Querschnitt durch eine weitere Ausgestaltung der erfindungsgemäßen Scheibe als Verbundscheibe,
- Fig. 4: ein Diagramm des Verhältnisses T_{L}/R_{L} in Abhängigkeit von der Dicke der Haftschicht,
- Fig. 5: ein Diagramm des Verhältnisses T_{L}/R_{L} in Abhängigkeit von der Dicke der funktionellen Schicht,
- Fig. 6: ein Diagramm des Verhältnisses T_{L}/R_{L} in Abhängigkeit von der Dicke der optisch hochbrechenden Schicht,
- Fig. 7: ein Diagramm des Verhältnisses T_{L}/R_{L} in Abhängigkeit von der Dicke der optisch niedrigbrechenden Schicht und
- Fig. 8: ein detailliertes Flussdiagramm einer Ausführungsform des erfindungsgemäßen Verfahrens.

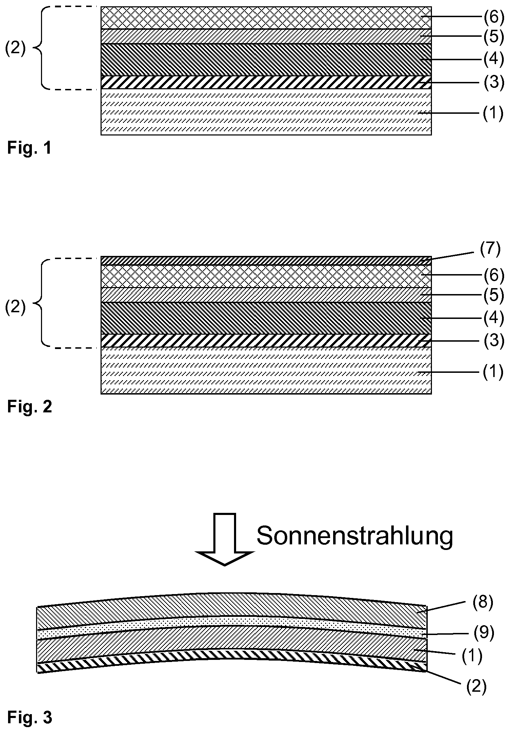

Fig. 1 zeigt einen Querschnitt durch eine Ausgestaltung der erfindungsgemäßen Scheibe mit dem Substrat 1 und der Wärmestrahlung reflektierenden Beschichtung 2. Das Substrat 1 enthält beispielsweise getöntes Kalk-Natron-Glas und weist eine Dicke von 6 mm auf. Die Beschichtung 2 umfasst eine Haftschicht 3, eine funktionelle Schicht 4, eine optisch hochbrechende Schicht 5 und eine optisch niedrigbrechende Schicht 6. Die Schichten sind in der angegebenen Reihenfolge mit wachsendem Abstand zum Substrat 1 angeordnet.

Die Haftschicht 3 besteht beispielsweise aus Aluminium-dotiertem Siliziumoxid und weist eine Dicke von 30 nm auf. Die funktionelle Schicht 4 besteht beispielsweise aus Indium-Zinnoxid (ITO) und weist eine Dicke von 130 nm auf. Die optisch hochbrechende Schicht 5 besteht beispielsweise aus Aluminium-dotiertem Siliziumnitrid und weist eine Dicke von 5 nm auf. Die optisch niedrigbrechende Schicht 6 besteht beispielsweise aus Aluminium-dotiertem Siliziumoxid und weist eine Dicke von 70 nm auf.

Die einzelnen Schichten der Beschichtung 2 wurden durch magnetfeldunterstützte Kathodenstrahlzerstäubung abgeschieden. Das Target zur Abscheidung der Haftschicht 3 und der optisch niedrigbrechende Schicht 6 enthielt 92 Gew. % Silizium und 8 Gew. % Aluminium. Die Abscheidung erfolgte unter Zugabe von Sauerstoff als Reaktionsgas während der Kathodenzerstäubung. Das Target zur Abscheidung der funktionellen Schicht 4 enthielt 90 Gew. % Indiumoxid und 10 Gew. % Zinnoxid. Die Abscheidung erfolgte unter einer Argon-Schutzgasatmosphäre mit einem Sauerstoffanteil von kleiner 1 %. Das Target zur Abscheidung der optisch hochbrechenden Schicht 5 enthielt 92 Gew. % Silizium und 8 Gew. % Aluminium. Die Abscheidung erfolgte unter Zugabe von Stickstoff als Reaktionsgas während der Kathodenzerstäubung.

Fig. 2 zeigt einen Querschnitt durch eine weitere Ausgestaltung der erfindungsgemäßen Scheibe mit dem Substrat 1 und der Wärmestrahlung reflektierenden Beschichtung 2. Die Beschichtung 2 ist wie in Figur 1 ausgestaltet mit der Haftschicht 3, der funktionellen Schicht 4, der optisch hochbrechenden Schicht 5 und der optisch niedrigbrechenden Schicht 6. Oberhalb der optisch niedrigbrechenden Schicht 6 ist eine Abdeckschicht 7 angeordnet. Die Abdeckschicht enthält TiO₂ und weist eine Dicke von 10 nm auf. Durch die Abdeckschicht wird die Beschichtung 2 vorteilhaft vor mechanischer Beschädigung, insbesondere vor Verkratzen geschützt.

Fig. 3 zeigt einen Querschnitt durch eine erfindungsgemäße Scheibe mit Wärmestrahlung reflektierender Beschichtung 2 als Verbundscheibe. Das Substrat 1 ist über eine thermoplastische Zwischenschicht 9 mit einer Deckscheibe 8 verbunden. Die Verbundscheibe ist als Dachscheibe für ein Kraftfahrzeug vorgesehen. Die Verbundscheibe ist gebogen, wie es für Scheiben im Automobilbereich üblich ist. In Einbaulage der Verbundscheibe ist die Deckscheibe 8 der äußeren Umgebung und das Substrat 1 dem Fahrzeuginnenraum zugewandt. Die innenraumseitige Oberfläche des Substrats 1, welche von der Deckscheibe 8 und der thermoplastischen Zwischenschicht 9 abgewandt ist, ist mit der erfindungsgemäßen Beschichtung 2 versehen. Die Substrat 1 und die Deckscheibe 8 bestehen aus Kalk-Natron-Glas und weisen jeweils eine Dicke von 2,1 mm auf. Die thermoplastische Zwischenschicht 9 enthält getöntes Polyvinylbutyral (PVB) und weist eine Dicke von 0,76 mm auf.

Das Substrat 1, die Deckscheibe 8 und die thermoplastische Zwischenschicht 9 sind getönt. Das Substrat 1 und die Deckscheibe 9 weisen beispielsweise jeweils eine Transmission im sichtbaren Spektralbereich von 27 % auf, die thermoplastisch Zwischenschicht 8 weist beispielsweise eine Transmission von 23 % auf. Die Verbundscheibe weist ohne die Beschichtung 2 eine innenraumseitige Transmission T_{L} im sichtbaren Spektralbereich von 2,3 % und eine innenraumseitige Reflexion R_{L} von 4,4% auf. Das Verhältnis T_{L}/R_{L} beträgt ohne die Beschichtung 2 0,5. Die erfindungsgemäße Wärmestrahlung reflektierende Beschichtung 2 verbessert überraschenderweise nicht nur den thermischen Komfort im Inneren des Kraftfahrzeugs, sonders wirkt auch als Antireflexionsbeschichtung. Die innenraumseitige Reflexion wird R_{L} durch die Beschichtung 2 auf 2,0% herabgesetzt. Das Verhältnis T_{L}/R_{L} wird durch die Beschichtung 2 auf 1,1 erhöht. Durch die Beschichtung 2 können Personen im Fahrzeuginnenraum die äußere Umgebung besser wahrnehmen und werden weniger durch Reflexionen gestört.

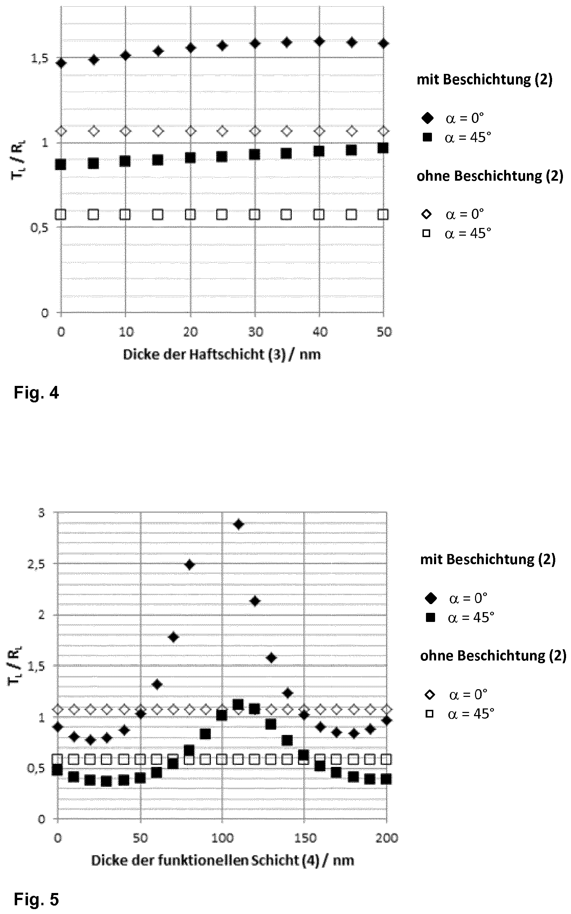

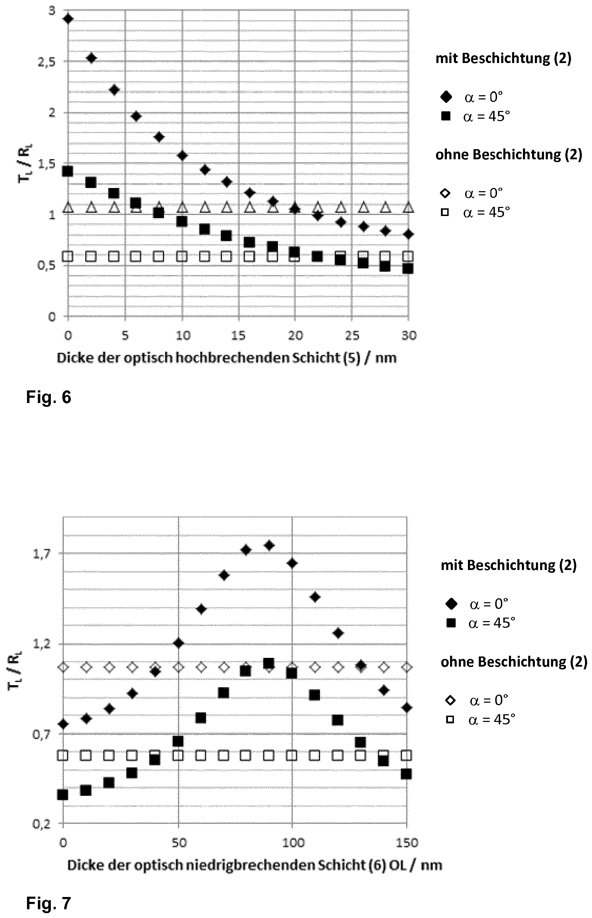

Fig. 4, Fig. 5, Fig. 6 und Fig. 7 zeigen Ergebnisse von Simulationen des Verhältnisses T_{L}/R_{L} des Transmissionsgrads T_{L} im sichtbaren Spektralbereich zum Reflexionsgrad R_{L} im sichtbaren Spektralbereich. Je größer das Verhältnis T_{L}/R_{L} ist, desto weniger ausgeprägt sind störende innenraumseitige Reflexionen und desto angenehmer ist der optische Eindruck von der Scheibe. In Fig. 4 ist das Verhältnis T_{L}/R_{L} in Abhängigkeit von der Dicke der Haftschicht 3 dargestellt. In Fig. 5 ist das Verhältnis T_{L}/R_{L} in Abhängigkeit von der Dicke der funktionellen Schicht 4 dargestellt. In Fig. 6 ist das Verhältnis T_{L}/R_{L} in Abhängigkeit von der Dicke der optisch hochbrechenden Schicht 5 dargestellt. In Fig. 7 ist das Verhältnis T_{L}/R_{L} in Abhängigkeit von der Dicke der optisch niedrigbrechenden Schicht 6 dargestellt.

Die Simulationen gehen von dem grundsätzlichen Schichtaufbau aus, dessen Schichtenfolge mit Materialen und Schichtdicken in Tabelle 1 dargestellt sind. Es wurde jeweils eine der Schichtdicken variiert, die übrigen Schichtdicken entsprachen den Werten in Tabelle 1. Die Gesamtheit aus Substrat 1, thermoplastischer Zwischenschicht 8 und Deckglas 9 hatte ohne die Beschichtung 2 eine Transmission T_{L} von etwa 4,2 %.

Zum Vergleich ist in den Figuren das Verhältnis T_{L}/R_{L} ohne die Beschichtung 2 dargestellt. Die Werte sind jeweils für zwei verschiedene Beobachtungswinkel α angegeben. Der Winkel α ist dabei der Winkel zwischen der Beobachtungsrichtung (Verbindungslinie zwischen Beobachter und Scheibe) und der Flächennormalen der Scheibe.

**Tabelle 1**

| Bezugszeichen | | Material | Dicke |
|---|---|---|---|
| 6 | 2 | Si0₂:AI | 70 nm |
| 5 | | Si₃N₄:Al | 10 nm |
| 4 | | ITO | 130 nm |
| 3 | | SiO₂:Al | 30 nm |
| 1 | | Glas | 2,1 mm |
| 8 | | PVB | 0,76 mm |
| 9 | | Glas | 3,15 mm |

Die absoluten Werte für das Verhältnis T_{L}/R_{L} hängen von der Transmission durch die Scheibe ab. Eine geringere Transmission bei gleichbleibender Reflexion führt zu geringerem Verhältnis T_{L}/R_{L}. Das bedeutet, dass die gleiche Beschichtung 2 auf einer Scheibe mit geringerer Transmission zu einem geringeren Verhältnis T_{L}/R_{L} führt als auf einer Scheibe mit höherer Transmission. Die qualitative Abhängigkeit des Verhältnisses T_{L}/R_{L} ist jedoch von der Transmission der Scheibe unabhängig und kann den Figuren entnommen werden.

Aus Fig. 4 ist ersichtlich, dass das Verhältnis T_{L}/R_{L} keine deutliche Abhängigkeit von der Dicke der Haftschicht 3 aufweist. Die Dicke der Haftschicht 3 beeinflusst die antireflektierenden Eigenschaften der Beschichtung 2 also kaum. Die Dicke der Haftschicht 3 kann daher auf Grundlage der haftvermittelnden Eigenschaften und der Barrierewirkung gegenüber diffundierenden Ionen ausgewählt werden. Es hat sich gezeigt, dass mit einer Haftschicht mit einer Dicke von 10 nm bis 150 nm, bevorzugt von 15 nm bis 50 nm besonders gute Ergebnisse erzielt werden.

Aus Fig. 5 ist ersichtlich, dass die Dicke der funktionellen Schicht 4 einen deutlichen Einfluss auf die antireflektierenden Eigenschaften der Beschichtung 2 und damit auf das Verhältnis T_{L}/R_{L} hat. Das Maximum für das Verhältnis T_{L}/R_{L} wird bei einer Dicke von etwa 100 nm erreicht. Um die Wärmestrahlung reflektierende Wirkung zu verbessern, kann jedoch eine dickere funktionelle Schicht 4 gewünscht sein. Es hat sich gezeigt, dass für Dicken der funktionellen Schicht 4 von 50 nm bis 150 nm, bevorzugt von 60 nm bis 140 nm, besonders bevorzugt von 70 nm bis 130 nm ein guter Kompromiss zwischen dem Verhältnis T_{L}/R_{L} und der Wärmestrahlung reflektierenden Wirkung erreicht wird.

Aus Fig. 6 ist ersichtlich, dass die Dicke der optisch hochbrechenden Schicht 5 einen deutlichen Einfluss auf die antireflektierenden Eigenschaften der Beschichtung 2 und damit auf das Verhältnis T_{L}/R_{L} hat. Das Verhältnis T_{L}/R_{L} wird größer, je dünner die optisch hochbrechende Schicht 5 ausgebildet ist. Bei einer Dicke von kleiner als 20 nm ist das Verhältnis T_{L}/R_{L} größer als bei der Scheibe ohne Beschichtung 2. Besonders gute Ergebnisse werden für eine Dicke der optisch hochbrechenden Schicht 5 von kleiner als 12 nm, bevorzugt kleiner als 10 nm, besonders bevorzugt kleiner als 8 nm erreicht. Damit die optisch hochbrechenden Schicht 5 die funktionelle Schicht 4 dennoch effektiv vor Korrosion und Oxidation schützen kann, sollte sie eine Dicke von mindestens 1 nm, bevorzugt mindestens 2 nm aufweisen.

Aus Fig. 7 ist ersichtlich, dass die Dicke der optisch niedrigbrechenden Schicht 6 einen deutlichen Einfluss auf die antireflektierenden Eigenschaften der Beschichtung 2 und damit auf das Verhältnis T_{L}/R_{L} hat. Bei einer Dicke von etwa 40 nm bis 130 nm ist das Verhältnis T_{L}/R_{L} größer als bei der Scheibe ohne Beschichtung 2. Besonders gute Ergebnisse werden für eine Dicke der optisch niedrigbrechenden Schicht 6 von 50 nm bis 120 nm, bevorzugt von 60 nm bis 110 nm, besonders bevorzugt von 70 nm bis 100 nm erreicht.

Durch die erfindungsgemäße Beschichtung 2 wird nicht nur eine Wärmestrahlung reflektierende Wirkung erzielt, sondern außerdem auch eine antireflektierende Wirkung. Wird die Beschichtung 2 auf eine Scheibe mit geringer Lichttransmission aufgebracht, so vermindert sie störende und irritierende innenraumseitige Reflexionen. Die antireflektierende Wirkung ist auch bei schrägem Lichteinfall noch stark ausgeprägt. Diese Ergebnisse waren für den Fachmann unerwartet und überraschend.

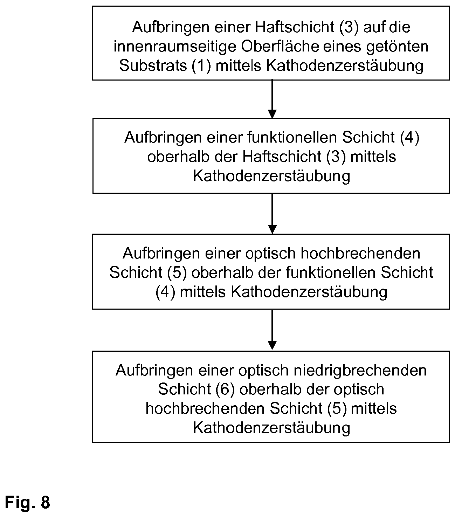

Fig. 8 zeigt ein Flussdiagramm eines Ausführungsbeispiels des erfindungsgemäßen Verfahrens zur Herstellung einer Scheibe mit Wärmestrahlung reflektierender Beschichtung 2.

### Bezugszeichenliste:

(1) Substrat
(2) Wärmestrahlung reflektierende Beschichtung
(3) Haftschicht
(4) funktionelle Schicht
(5) optisch hochbrechende Schicht
(6) optisch niedrigbrechende Schicht
(7) Abdeckschicht
(8) Deckscheibe
(9) thermoplastische Zwischenschicht

## Patentansprüche

1. Scheibe mit Wärmestrahlung reflektierender Beschichtung zur Abtrennung eines Innenraums gegenüber einer äußeren Umgebung, umfassend mindestens ein Substrat (1) und mindestens eine Wärmestrahlung reflektierende Beschichtung (2) mindestens auf der Oberfläche des Substrats (1), die dafür vorgesehen ist, in Einbaulage der Scheibe dem Innenraum zugewandt zu sein, wobei
- die Scheibe eine Transmission im sichtbaren Spektralbereich kleiner als 5 % aufweist und
- die Beschichtung (2), ausgehend vom Substrat (1), mindestens umfasst:
- eine Haftschicht (3), welche zumindest ein Material mit einem Brechungsindex von kleiner als 1,8 enthält,
- eine funktionelle Schicht (4), die zumindest ein transparentes, elektrisch leitfähiges Oxid enthält,
- eine optisch hochbrechende Schicht (5), welche zumindest ein Material mit einem Brechungsindex von größer oder gleich 1,8 enthält, und
- eine optisch niedrigbrechende Schicht (6), welche zumindest ein Material mit einem Brechungsindex von kleiner als 1,8 enthält.

2. Scheibe nach Anspruch 1, die eine Verbundscheibe ist, wobei das Substrat (1) über zumindest eine thermoplastische Zwischenschicht (9) mit einer Deckscheibe (8) verbunden ist.

3. Scheibe nach Anspruch 1 oder 2, die eine Transmission im sichtbaren Spektralbereich von kleiner als 4 %, bevorzugt kleiner 3 % aufweist.

4. Scheibe nach einem der Ansprüche 1 bis 3, wobei die Haftschicht (3) zumindest ein Oxid enthält, bevorzugt Siliziumoxid und/oder Aluminiumoxid, besonders bevorzugt Aluminium-dotiertes Siliziumdioxid, Zirkonium-dotiertes Siliziumdioxid oder Bor-dotiertes Siliziumdioxid.

5. Scheibe nach einem der Ansprüche 1 bis 4, wobei die Haftschicht (3) eine Dicke von 10 nm bis 150 nm, bevorzugt von 15 nm bis 50 nm aufweist.

6. Scheibe nach einem der Ansprüche 1 bis 5, wobei die funktionelle Schicht (4) zumindest Fluor-dotiertes Zinnoxid, Antimon-dotiertes Zinnoxid und / oder Indium-Zinn-Oxid enthält.

7. Scheibe nach einem der Ansprüche 1 bis 6, wobei die funktionelle Schicht (4) eine Dicke von 50 nm bis 150 nm, bevorzugt von 60 nm bis 140 nm, besonders bevorzugt von 70 nm bis 130 nm aufweist.

8. Scheibe nach einem der Ansprüche 1 bis 7, wobei die optisch hochbrechende Schicht (5) zumindest ein Oxid oder Nitrid enthält, bevorzugt Wolframoxid, Nioboxid, Tantaloxid, Zirkoniumoxid, Hafniumoxid, Bismutoxid, Titanoxid, Siliziumnitrid, Zirkoniumnitrid, Hafniumnitrid, und/oder Aluminiumnitrid, besonders bevorzugt Siliziumnitrid, ganz besonders bevorzugt Aluminium-dotiertes Siliziumnitrid, Zirkonium-dotiertes Siliziumnitrid oder Bor-dotiertes Siliziumnitrid.

9. Scheibe nach einem der Ansprüche 1 bis 8, wobei die optisch hochbrechende Schicht (5) eine Dicke von mindestens 1 nm und von kleiner als 20 nm aufweist, bevorzugt kleiner als 12 nm, besonders bevorzugt kleiner als 10 nm, ganz besonders bevorzugt kleiner als 8 nm.

10. Scheibe nach einem der Ansprüche 1 bis 9, wobei die optisch niedrigbrechende Schicht (6) zumindest ein Oxid enthält, bevorzugt Siliziumoxid und/oder Aluminiumoxid, besonders bevorzugt Aluminium-dotiertes Siliziumoxid, Zirkonium-dotiertes Siliziumoxid oder Bor-dotiertes Siliziumoxid.

11. Scheibe nach einem der Ansprüche 1 bis 10, wobei die optisch niedrigbrechende Schicht (6) eine Dicke von 40 nm bis 130 nm, bevorzugt von 50 nm bis 120 nm, besonders bevorzugt von 60 nm bis 110 nm, ganz besonders bevorzugt von 70 nm bis 100 nm aufweist.

12. Scheibe nach einem der Ansprüche 1 bis 11, wobei oberhalb der optisch niedrigbrechenden Schicht (6) eine Abdeckschicht (7) angeordnet ist, die zumindest ein Oxid, bevorzugt zumindest TiO₂, ZrO₂, HfO₂, Nb₂O₅, Ta₂O₅, Cr₂O₃, WO₃ und / oder CeO₂ enthält und die bevorzugt eine Dicke von 2 nm bis 50 nm, besonders bevorzugt von 5 nm bis 20 nm aufweist.

13. Verfahren zur Herstellung einer Scheibe mit Wärmestrahlung reflektierender Beschichtung (2) nach einem der Ansprüche 1 bis 12, wobei auf die Oberfläche des Substrats (1), die dafür vorgesehen ist, in Einbaulage der Scheibe dem Innenraum zugewandt zu sein, nacheinander zumindest
(a) die Haftschicht (3),
(b) die funktionelle Schicht (4),
(c) die optisch hochbrechende Schicht (5) und
(d) die optisch niedrigbrechende Schicht (6)
aufgebracht werden.

14. Verwendung der Scheibe mit Wärmestrahlung reflektierender Beschichtung nach einen der Ansprüche 1 bis 12 in Gebäuden oder in Fortbewegungsmitteln für den Verkehr auf dem Lande, in der Luft oder zu Wasser, insbesondere in Zügen, Schiffen und Kraftfahrzeugen beispielsweise als Heckscheibe, Seitenscheibe und/oder Dachscheibe.

## Claims

1. Pane with thermal radiation reflecting coating for separating an interior from an external environment, comprising at least one substrate (1) and at least one thermal radiation reflecting coating (2) at least on the surface of the substrate (1) that is intended to be turned toward the interior in the installed position of the pane, wherein
- the pane has transmittance in the visible spectral range of less than 5%, and
- the coating (2), proceeding from the substrate (1), comprises at least:
- an adhesive layer (3) that contains at least one material with a refractive index of less than 1.8,
- a functional layer (4) that contains at least one transparent, electrically conductive oxide,
- an optically high-refractive-index layer (5) that contains at least one material with a refractive index greater than or equal to 1.8, and
- an optically low-refractive-index layer (6) that contains at least one material with a refractive index of less than 1.8.

2. Pane according to claim 1, which is a composite pane, wherein the substrate (1) is bonded to a cover pane (8) via at least one thermoplastic intermediate layer (9).

3. Pane according to claim 1 or 2, which has transmittance in the visible spectral range of less than 4%, preferably less than 3%.

4. Pane according to any one of claims 1 through 3, wherein the adhesive layer (3) contains at least one oxide, preferably silicon oxide and/or aluminum oxide, particularly preferably aluminum-doped silicon dioxide, zirconium-doped silicon dioxide, or boron-doped silicon dioxide.

5. Pane according to any one of claims 1 through 4, wherein the adhesive layer (3) has a thickness from 10 nm to 150 nm, preferably from 15 nm to 50 nm.

6. Pane according to any one of claims 1 through 5, wherein the functional layer (4) contains at least fluorine-doped tin oxide, antimony-doped tin oxide, and/or indium tin oxide.

7. Pane according to any one of claims 1 through 6, wherein the functional layer (4) has a thickness from 50 nm to 150 nm, preferably from 60 nm to 140 nm, particularly preferably from 70 nm to 130 nm.

8. Pane according to any one of claims 1 through 7, wherein the optically high-refractive-index layer (5) contains at least one oxide or nitride, preferably tungsten oxide, niobium oxide, tantalum oxide, zirconium oxide, hafnium oxide, bismuth oxide, titanium oxide, silicon nitride, zirconium nitride, hafnium nitride, and/or aluminum nitride, particularly preferably silicon nitride, most particularly preferably aluminum-doped silicon nitride, zirconium-doped silicon nitride, or boron-doped silicon nitride.

9. Pane according to any one of claims 1 through 8, wherein the optically high-refractive-index layer (5) has a thickness of at least 1 nm and of less than 20 nm, preferably of less than 12 nm, particularly preferably of less than 10 nm, most particularly preferably of less than 8 nm.

10. Pane according to any one of claims 1 through 9, wherein the optically low-refractive-index layer (6) contains at least one oxide, preferably silicon oxide and/or aluminum oxide, particularly preferably aluminum-doped silicon oxide, zirconium-doped silicon oxide, or boron-doped silicon oxide.

11. Pane according to any one of claims 1 through 10, wherein the optically low-refractive-index layer (6) has a thickness from 40 nm to 130 nm, preferably from 50 nm to 120 nm, particularly preferably from 60 nm to 110 nm, most particularly preferably from 70 nm to 100 nm.

12. Pane according to any one of claims 1 through 11, wherein a cover layer (7) that contains at least one oxide, preferably at least TiO₂, ZrO₂, HfO₂, Nb₂O₅, Ta₂O₅, Cr₂O₃, WO₃, and/or CeO₂ and that preferably has a thickness from 2 nm to 50 nm, particularly preferably from 5 nm to 20 nm is arranged above the optically low-refractive-index layer (6).

13. Method for producing a pane with thermal radiation reflecting coating (2) according to any one of claims 1 through 12, wherein at least
(a) the adhesive layer (3),
(b) the functional layer (4),
(c) the optically high-refractive-index layer (5), and
(d) the optically low-refractive-index layer (6)
are applied in succession on the surface of the substrate (1) that is intended to be turned toward the interior in the installed position of the pane.

14. Use of the pane with thermal radiation reflecting coating according to any one of claims 1 through 12 in buildings or in means of transportation for travel on land, in the air, or on water, in particular in trains, ships, and motor vehicles, for example, as a rear window, side window, and/or roof panel.

## Revendications

1. Vitre avec un revêtement réfléchissant le rayonnement thermique pour séparer un intérieur d'un environnement extérieur, comprenant au moins un substrat (1) et au moins un revêtement réfléchissant le rayonnement thermique (2) au moins sur la surface du substrat (1) qui est destinée à être tournée vers l'intérieur dans la position installée de la vitre, dans laquelle
- la vitre a une transmittance dans le domaine spectral visible inférieure à 5 %, et
- le revêtement (2), partant du substrat (1), comprend au moins :
- une couche adhésive (3) qui contient au moins un matériau ayant un indice de réfraction inférieur à 1,8,
- une couche fonctionnelle (4) qui contient au moins un oxyde transparent et électriquement conducteur,
- une couche d'indice de réfraction optiquement élevé (5) qui contient au moins un matériau ayant un indice de réfraction supérieur ou égal à 1,8, et
- une couche d'indice de réfraction optiquement faible (6) qui contient au moins un matériau ayant un indice de réfraction inférieur à 1,8.

2. Vitre selon la revendication 1, qui est une vitre composite, dans laquelle le substrat (1) est lié à une vitre de recouvrement (8) par l'intermédiaire d'au moins une couche intermédiaire thermoplastique (9).

3. Vitre selon la revendication 1 ou 2, qui a une transmittance dans le domaine spectral visible inférieure à 4 %, de préférence inférieure à 3 %.

4. Vitre selon l'une quelconque des revendications 1 à 3, dans lequel la couche adhésive (3) contient au moins un oxyde, de préférence de l'oxyde de silicium et/ou de l'oxyde d'aluminium, de préférence en particulier du dioxyde de silicium dopé à l'aluminium, du dioxyde de silicium dopé au zirconium ou du dioxyde de silicium dopé au bore.

5. Vitre selon l'une quelconque des revendications 1 à 4, dans lequel la couche adhésive (3) a une épaisseur de 10 nm à 150 nm, de préférence de 15 nm à 50 nm.

6. Vitre selon l'une quelconque des revendications 1 à 5, dans lequel la couche fonctionnelle (4) contient au moins de l'oxyde d'étain dopé au fluor, de l'oxyde d'étain dopé à l'antimoine et/ou de l'oxyde d'étain et d'indium.

7. Vitre selon l'une quelconque des revendications 1 à 6, dans lequel la couche fonctionnelle (4) a une épaisseur de 50 nm à 150 nm, de préférence de 60 nm à 140 nm, particulièrement de 70 nm à 130 nm.

8. Vitre selon l'une quelconque des revendications 1 à 7, dans lequel la couche d'indice de réfraction optiquement élevé (5) contient au moins un oxyde ou un nitrure, de préférence l'oxyde de tungstène, l'oxyde de niobium, l'oxyde de tantale, l'oxyde de zirconium, l'oxyde de hafnium, l'oxyde de bismuth, l'oxyde de titane, le nitrure de silicium, le nitrure de zirconium, le nitrure d'hafnium et/ou le nitrure d'aluminium, de préférence le nitrure de silicium, de préférence le nitrure de silicium dopé à l'aluminium, le nitrure de silicium dopé au zirconium ou le nitrure de silicium dopé au bore.

9. Vitre selon l'une quelconque des revendications 1 à 8, dans lequel la couche d'indice de réfraction optiquement élevé (5) a une épaisseur d'au moins 1 nm et de moins de 20 nm, de préférence de moins de 12 nm, de manière particulièrement préférée de moins de 10 nm, de manière particulièrement préférée de moins de 8 nm.

10. Vitre selon l'une quelconque des revendications 1 à 9, dans lequel la couche d'indice de réfraction optiquement faible (6) contient au moins un oxyde, de préférence de l'oxyde de silicium et/ou de l'oxyde d'aluminium, plus particulièrement de l'oxyde de silicium dopé à l'aluminium, de l'oxyde de silicium dopé au zirconium ou de l'oxyde de silicium dopé au bore.

11. Vitre selon l'une quelconque des revendications 1 à 10, dans lequel la couche d'indice de réfraction optiquement faible (6) présente une épaisseur de 40 nm à 130 nm, de préférence de 50 nm à 120 nm, de manière particulièrement préférée de 60 nm à 110 nm, de manière particulièrement préférée de 70 nm à 100 nm.

12. Vitre selon l'une quelconque des revendications 1 à 11, dans lequel une couche de recouvrement (7), qui contient au moins un oxyde, de préférence au moins TiO₂, ZrO₂, HfO₂, Nb₂O₅, Ta₂O₅, Cr₂O₃, WO₃ et/ou CeO₂ et qui présente de préférence une épaisseur de 2 nm à 50 nm, de manière particulièrement préférée de 5 nm à 20 nm, est disposée au-dessus de la couche d'indice de réfraction optiquement faible (6).

13. Procédé de fabrication d'une vitre avec un revêtement réfléchissant le rayonnement thermique (2) selon l'une quelconque des revendications 1 à 12, dans lequel au moins
a) la couche adhésive (3),
b) la couche fonctionnelle (4),
c) la couche d'indice de réfraction optiquement élevé (5), et
d) la couche d'indice de réfraction optiquement faible (6)
sont appliqués successivement sur la surface du support (1) qui est destiné à être tourné vers l'intérieur dans la position installée du vitre.

14. Utilisation de la vitre avec un revêtement réfléchissant le rayonnement thermique selon l'une des revendications 1 à 12 dans des bâtiments ou dans des moyens de transport pour les déplacements sur terre, dans les airs ou sur l'eau, en particulier dans les trains, les bateaux et les véhicules à moteur, par exemple, comme vitre arrière, vitre latérale et/ou vitre de toit.
